(19) Europäisches Patentamt
European Patent Office
Office européen des brevets

(11) Publication number: **0 130 755**
**B1**

(12) **EUROPEAN PATENT SPECIFICATION**

(45) Date of publication of patent specification: **24.08.88**

(51) Int. Cl.$^4$: **G 11 B 7/24** // C01B19/00

(21) Application number: **84304250.8**

(22) Date of filing: **22.06.84**

(54) **Method of producing optical recording medium.**

(30) Priority: **27.06.83 JP 116317/83**
**09.12.83 JP 233009/83**

(43) Date of publication of application:
**09.01.85 Bulletin 85/02**

(45) Publication of the grant of the patent:
**24.08.88 Bulletin 88/34**

(84) Designated Contracting States:
**DE FR GB**

(56) References cited:
**DE-A-2 933 253**
**US-A-3 971 874**
**US-A-4 357 366**

**JOURNAL OF APPLIED PHYSICS, vol. 54, no. 9, September 1983, pages 5376-5380, New York (USA); MATSUO TAKENAGA et al:"TeOx thin films for an optical disc memory"**

(73) Proprietor: **Matsushita Electric Industrial Co., Ltd.**
**1006, Oaza Kadoma**
**Kadoma-shi Osaka-fu, 571 (JP)**

(72) Inventor: **Yamada, Noboru**
**4-2, 1-chome, Kusuhaoka**
**Hirakata-shi Osaka-fu, 573 (JP)**
Inventor: **Nishiuchi, Kenichi**
**4-49 Satanaka-machi**
**Moriguchi-shi Osaka-fu, 570 (JP)**
Inventor: **Takenaga, Mutsuo**
**12-305, 4-chome, Ikuno**
**Katano-shi Osaka-fu, 576 (JP)**

(74) Representative: **Austin, Hedley William et al**
**A.A. THORNTON & CO. Northumberland House**
**303-306 High Holborn**
**London WC1V 7LE (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 130 755 B1

## Description

This invention relates to a method of producing an optical recording medium capable of recording information which may be subsequently erased.

US—A—3,971,874 proposes a recording material having a thin film whose fundamental material is tellurium suboxide of the formula [$TeO_x$] (0<x<2). When the thin film is irradiated with light such as a laser beam, the temperature thereof increases and thereby the optical density of the thin film increases.

In the material expressed by the formula [$TeO_x$], one of the composition models of the material is one where fine grains of Te are distributed in (stoichiometric) tellurium oxide $TeO_2$. The fine grains of Te collect together on irradiation with light and thereby increase in particle size. As a result, the reflective index and extinction coefficient in the illuminated area change so that information may be recorded as desired. By detecting the changes in the reflectivity and transmission of this thin film, the recorded information may be reproduced.

Thin films comprising tellurium suboxide are used for recording discs for still picture file systems, document file systems and others in view of the high sensitivity and high signal quality of the films.

Various methods of producing a thin film of [TeOx] (0<x<2) have been proposed, as follows:

(1) A method of vacuum deposition of a $TeO_2$ powder source on a tungsten or molybdenum boat. For example, US—A—3,971,874 discloses a method in which the tungsten or molybdenum boat is heated to cause reduction reaction with the $TeO_2$ on the boat surface, and vacuum deposition is conducted while removing part of the oxygen from the $TeO_2$ in order to obtain a thin film of [$TeO_x$] (0<x<2).

(2) A method of producing a thin film of [TeOx] (0<x<2) by using a source of Te and a source of $TeO_2$ which are evaporated and deposited simultaneously on a board, with control of the vacuum deposition temperature of the individual sources. (For example, such a method is disclosed in the Proceedings of the 28th Joint Assembly of Applied Physics Associations, p. 108, 1981).

(3) A method in which a reducing metal and $TeO_2$ are mixed and the mixture is evaporated (and the $TeO_2$ reduced) by heating in a quartz crucible using a coil heater or the like. (Such a method is disclosed in the Proceeding of the 28th Joint Assembly of Applied Physics Associations, p. 108, 1981, and the Proceedings of SPIE, Vol. 329, Optical Disk Technology, p. 195, 1982).

Erasable optical information recording thin films containing [TeOx] (0<x<2) as the principal material and additives can also be produced by the methods disclosed in US—A—4,278,734, EP—A—0 121 426 and Proceedings of SPIE, Vol. 420, Optical Storage Media, pages 173—177. In these methods selenium, sulphur, germanium, tin, or the like are used as additives.

These erasable optical information recording thin films may be used repeatedly, and higher homogeneity and reproducibility of film composition are required than those in the conventional recording thin films of non-erasable (single recording) type.

The following methods have been proposed to produce additive-containing tellurium suboxide films:

(1) Using $TeO_2$ and Te sources as the principal materials and, for example, Ge and Sn sources as the additives, and evaporating them simultaneously on a board by controlling the heating temperature of each source in the plurality of sources. (Such a method is disclosed in EP—A—0 121 426 and Proceedings of 1983 Japan Display pp. 46 to 48).

(2) Using $TeO_2$ source and an alloy source of Te with additives such as Ge and Sn, and evaporating them on a board by controlling the heating temperature of each source. (Such a method is disclosed in EP—A—0 121 426.

(3) A method involving vacuum deposition, in which the mixed raw material comprising $TeO_2$ and metal or semimetal additive is placed on a reducing metal boat, such as a tungsten or molybdenum boat. (Such a method is disclosed in US—A—4,278,734 and EP—A—0 121 426). In this method, the metal boat is heated to cause reduction of $TeO_2$ on the boat surface, and vacuum deposition is performed while removing part of the oxygen from $TeO_2$ to obtain a thin film of [TeOx] (0<x<2) containing the additive.

(4) A method involving vacuum deposition and further mixing powder of Fe, Cr, W or the like as reducing agent, in a method according to (3), preliminarily into the mixture of $TeO_2$ and additive, instead of using a metallic boat. (Such a method is disclosed in EP—A—0 121 426). In this method, the raw materials are put in a quartz crucible or other inert receptacle, and the outer wall of the receptacle is heated by coil heater or the like to cause reduction of the $TeO_2$ and a thin film of tellurium suboxide containing the additive is obtained by evaporating while removing part of oxygen from $TeO_2$.

The present invention is principally concerned with a method of producing an optical recording medium comprising [TeOx] (0<x<2) thin film easily, efficiently, with uniform quality, and excellent reproducibility. In a first embodiment of the invention, the method comprises the steps of:

(a) heat treating a mixture of tellurium dioxide and a reducing agent M so as to cause reaction of said tellurium dioxide with said reducing agent and production of a sintered body, and

(b) producing an optical recording layer comprising a tellurium compound on a substrate by vacuum deposition using said sintered body or a body obtained therefrom as the evaporation source.

In one of the embodiments of the present invention, a mortar is used in the first step, in which tellurium dioxide $TeO_2$ and reducing substance are mixed. A ball mill may be used instead of the mortar. In the second step, an electric

furnace is used, and the mixture obtained in the first step is dried, put on a quartz boat and placed into the electric furnace to be heated in an inert gas atmosphere, so that a sintered body is formed. The heat treatment temperature is set within a range of 400°C to 1,000°C. It is further effective to define this heating range within 600°C to 700°C. As the reducing substance, at least one element may be selected from the group consisting of Al, Si, Ti, V, Cd, In, Sn, Sb, Ta, W, Cr, Mn, Fe, Co, Ni, Cu, Zn, Ge, Mo, Bi, Pb, S, Se, and C. If the reducing substance is M, the sintered body is at least an aggregated body of M-Te alloy , M-O oxide and $TeO_2$.

As the reducing substance, at least one element selected from the group consisting of Cu, Sn, Pb, Al, In, Zn, Bi, Ge, Se, and Cd is effective, and, in particular, at least one element selected from the group consisting of Cu, Al, Sb, Pb, and In is more preferable. The mixing ratio $\alpha$ of this reducing substance may be set within a range of 15 mol % $\leq\alpha\leq$80 mol%.

In step (b), a vacuum deposition apparatus is used, and the sintered body obtained in the previous step is put in a quartz container, heated by a proper heating means, and a tellurium compound optical recording thin film is evaporated on a board placed on a support stand. The heating means may include heater or electron beam. In case that an electron beam may be used as the heating means, pellets may be used as the vacuum deposition source. This pellet source is obtained by pulverizing the sintered body and compacting and forming the pulverized sintered body by a press.

The degree of vacuum of the vacuum deposition apparatus may be set in a range of $133.322\times10^{-3}$ Pa to $133.322\times10^{-7}$ Pa ($10^{-3}$ Torr to $10^{-7}$ Torr), more preferably below $133.322\times10^{-5}$ Pa ($10^{-5}$ Torr).

In another embodiment, Cu is selected as the reducing substance and its mixing ratio $\alpha$ is set within $15\leq\alpha\leq80$ mol%.

In still another embodiment, Al is selected as the reducing substance and its mixing ratio $\alpha$ is set within 20 mol%$\leq\alpha\leq$60 mol%.

In further embodiment, Al and Cu are selected as the reducing substances and are mixed simultaneously, with their mixing ratios $\alpha_1$, $\alpha_2$ being preferably defined within 15 mol%$\leq\alpha_1\leq$50 mol%, 20 mol%$\leq\alpha_2\leq$60 mol%, and 50 mol%$\leq\alpha_1+\alpha_2\leq$80 mol%.

Another method of producing an optical recording medium includes a first step of mixing tellurium dioxide $TeO_2$ and reducing substance, a second step of heat-treating the mixture obtained in the first step and causing part of $TeO_2$ to react with the reducing substance to form a sintered body a third step of mixing the additive for enhancing the erasability of optical recording medium to the sintered body obtained in the second step, and a fourth step of evaporating an tellurium oxide compound optical recording thin film on a board by using the mixture obtained in the third step as the vacuum deposition source.

In the embodiment, as the additives, Ti, V, Ta, Cr, Mo, W, Mn, Fe, Co, Ni, Pt, Cu, Ag, Zn, Cd, Al, In, Tl, Si, Ge, Sn, Pb, As, Sb, Bi, S, Se, and Au may be used either alone or in oxide form, independently or as compound of substances. The content $\beta$ of the additives may be set in a range of 10 weight (wt.)%$\leq\beta\leq$40 wt.%.

Preferably, as the additive, at least one element selected from a group comprising Zn, Cd, In, Tl, Ge, Sn, Pb, As, Sb, Bi, S and Se is effective, and at least one element selected from a group comprising Ge, Sn, Se, Bi, In and Zn is more preferable.

The content $\beta$ of the additive is particularly effective when set within a range of 10 wt.%$\leq\beta\leq$30 wt.%.

As the additive, it is also possible to use at least one compound selected from the group of compounds consisting of Ti-Te, V-Te, Ta-Te, Cr-Te, Mo-Te, W-Te, Mn-Te, Fe-Te, Co-Te, Ni-Te, Pt-Te, Cu-Te, Ag-Te, Zn-Te, Cd-Te, Al-Te, In-Te, Tl-Te, Si-Te, Ge-Te, Sn-Te, Pb-Te, As-Te, Sb-Te, Bi-Te, S-Te, Se-Te, and Au-Te.

It is also possible to use, as the additives, either independently or in combination the Te compounds selected from the group consisting of Ge-Te, Sn-Te, In-Te, Pb-Te, Sb-Te, Se-Te, Zn-Te, Al-Te, Bi-Te, Cu-Te and Au-Te.

As the vacuum deposition source, Ge may be combined with at least one compound selected from the group consisting of Sn-Te, In-Te, Pb-Te, Sb-Te, Se-Te, Zn-Te, Al-Te, Bi-Te, Cu-Te and Au-Te. In this case, the content $\beta$ of Ge is set in a range of 0 wt.%$<\beta<$10 wt.%.

In the fourth step of this embodiment, a vacuum deposition apparatus is used, and the mixture obtained in the third step is put in a quartz container, heated by a heating means, and a tellurium compound optical recording thin film is evaporated and formed on a board placed on a support stand. As the heating means, coil heater is used, and the heater temperature is set within a range of 500°C to 1,000°C.

It is effective to set the degree of vacuum of the vacuum deposition apparatus within a range of $133.322\times10^{-3}$ Pa to $133.322\times10^{-7}$ Pa ($10^{-3}$ Torr to $10^{-7}$ Torr), or more preferably below $133.322\times10^{-5}$ Pa ($10^{-5}$ Torr). As the heating means, an electron beam is used, and as the vacuum deposition source, the pellets obtained by compacting the mixture powder produced in the third step are used.

This invention provides various advantages, among other, which are as follows.

As compared with the conventional method of producing tellurium oxide compound thin films, the method of producing [TeOx] compound thin film as optical recording medium in the present invention provides the following features:

1) The uniformity of composition of [TeOx] compound thin film photosensitive layer is extremely enhanced.

2) Since there is only one vacuum deposition source, the structure of vacuum deposition apparatus is simple, and the source itself is a sintered body (a solid body) which is easy to handle and workable.

3) By mass production of sintered body, difference of quality is eliminated among the manufacturing lots of optical recording media.

Similarly, the method of introducing additives to the [TeOx] compound thin film having the same features 1) through 3) is achieved, so that erasable optical information recording thin films may be easily obtained.

The invention will now be more particularly described in the following detailed description, in conjunction with the drawings.

Fig. 1 is a sectional view showing the mixing operation of starting materials in a step to obtain sintered body as the vacuum deposition source of the present invention;

Fig. 2 is a sectional view of an electric furnace used for sintering;

Fig. 3 is a sectional view of an apparatus for producing [TeOx] compound thin films by using the sintered body;

Fig. 4 is a perspective view showing a pellet as the vacuum deposition source;

Fig. 5 is a sectional view of a press jig for forming the pellet;

Fig. 6 illustrates the difference in the humidity resistant characteristics due to difference in the vacuum deposition method of [TeOx] compound thin film;

Fig. 7 is a schematic diagram of an apparatus for recording and reproducing information signals on an optical disk produced by the method according to the present invention;

Fig. 8 is a graph showing the difference in the humidity resistant characteristics due to difference in the vacuum deposition method of [TeOx] compound thin film containing Sn as additive;

Fig. 9 is a schematic diagram of an apparatus for recording, reproducing and erasing information signals on an optical disk produced by the method according to the present invention; and

Fig. 10 shows the change in the O/Te ratio with respect to the content of Cu, when [TeOx] compound thin film is formed by using the sintered body produced by varying the Cu content to be added to $TeO_2$ in the heat treatment step.

Detailed description of the invention

As one of the features of the method of producing an optical recording medium in this invention, the mixture body obtained in the following steps is used as the vacuum deposition source.

(a) Step to make a mixture by mixing tellurium dioxide $TeO_2$ and reducing substance.

(b) Step to make a sintered body by heating the mixture obtained in the previous step and causing part of $TeO_2$ to react with the reducing substance.

(c) Step to make a mixture body by mixing additive to the powder obtained by pulverizing the above sintered body.

When vacuum deposition is performed by using the sintered body obtained in steps (a) and (b) as the vacuum deposition source, a pure [TeOx] thin film is obtained, and when vacuum deposition is performed by using the mixture body obtained in processes up to (c) as the vacuum deposition source together with the additive, an erasable [TeOx] compound thin film is obtained.

According to this invention, the majority of the reduced form of $TeO_2$ resulting from heat treatment is bonded with part of reducing metal M to form a compound Te-M, which is combined with unreacted $TeO_2$ and M-O oxidized as a result of reaction, thereby forming a uniform sintered body. At the time of vacuum deposition, $TeO_2$ in this sintered body and Te isolated from the Te-M bonding are simultaneously evaporated, and a thin film of [TeOx] ($0<x<2$) is formed on a board.

This method of using sintered body is free from the phenomenon of spilling of the source because the reaction is less violent as compared with the process of evaporating while reducing. Besides, since dissociation of Te progresses gradually at a constant speed, deviation of the chemical composition in the direction of film thickness hardly occurs. Moreover, since a large quantity of source is prepared at a time and necessary portions are dispensed for use, the reproducibility is far better than in other methods and films of identical characteristics may be obtained. In addition, a result of obtaining a thin film of [TeOx] resistant to humidity was observed.

Next, when mixing the additive material to the powder obtained by pulverizing this sintered body, by dispersing the additive uniformly into the sintered body powder, it may be uniformly contained in the [TeOx] thin film without obvious deviation in the chemical composition, with less isolation from the [TeOx] components during vacuum deposition process. When the vapor pressure and melting point of the additive material and [TeOx] material are selected as close to each other as possible, the additive concentration in the [TeOx] thin film becomes more uniform.

Figs. 1 through 3 illustrate the processes of making a sintered body in this invention.

Fig. 1 shows a mortar 10 in its sectional view, in which powder of tellurium dioxide $TeO_2$ and powder of reducing substance 14 (to be shown later) are put and mixed well by a pestle 16. A ball mill may be used in this mixing process instead of the mortar. By mixing the $TeO_2$ powder and reducing substance together with alcohol of acetone, a uniform mixture may be easily obtained. The mixed powder 18 is dried, put on a quartz boat 20, and heated in an electric furnace 21 as shown in Fig. 2. Fig. 2 shows a quartz core tube 22, heater 24, insulator 26, outer wall 28, and thermocouple 30. Heat treatment is effected in an inert gas atmosphere of $N_2$, Ar, or the like. The inlet and outlet of the gas are respectively indicated by numerals 32 and 34. The heat treatment temperature varies with the reducing substance, and approximately ranges from 400°C to 1,000°C. Reduction reaction in this range brought about a clean sintered body. That is, below 400°C, the reaction does not progress sufficiently, and over 1,000°C, the Te element is evaporated in a large quantity during heat treatment and neither is

preferable. One of the causes of this phenomenon is considered to relate to the melting point of the additive, or that of Te produced in the initial phase of reaction. Namely, the melting point of the additives mentioned above is, excluding that of Se, S, As, etc., relatively high such as about 1,000°C or higher, and therefore, reaction is difficult at low temperature.

Therefore, since the reaction proceeds in a form of melting into Te (melting point: 450°C) produced in the initial phase of reaction, it is estimated that the reaction hardly occurs below 400°C. On the other hand, over 1,000°C, since the temperature is close to the boiling point of Te (1390°C), it is considered that little Te remains in the sintered body. Particularly in a range of 600°C to 700°C, a clean sintered body with less volatile content, good reproducibility and sufficiently advanced reaction could be obtained. In the case of Se, S, As, etc., since the melting point thereof is lower than that of Te, a sufficient reaction is obtained at a temperature of around 400°C.

As the reducing substance M, at least one element may be selected from the group consisting of Al, Si, Ti, V, Cd, In, Sn, Sb, Ta, W, Cr, Mn, Fe, Co, Ni, Cu, Zn, Ge, Mo, Bi, Pb, and other metals or semi-metals, and S, Se, C, etc. For example, reducing substance M reacts with $TeO_2$ by heat treatment to induce a change as expressed by a formula

$$mTeO_2+nM \rightarrow TeM+MO+TeO_2$$

(where m, n are natural numbers). That is, part of $TeO_2$ is reduced by part of reducing substance M to become Te, and M simultaneously forms oxides such as MO, $M_2O_3$ and $MO_2$. At this time, the majority of Te produced by reduction is bonded with the reducing substance M which is left over unreacted to make compounds such as $M_2Te$, MTe, $M_2Te_3$ and $MTe_2$, which are contained in the sintered body. Therefore, the sintered body obtained as a result of heat treatment may be said to be an aggregated body of M-Te alloys, M-O oxides, and $TeO_2$.

Among the reducing substances mentioned above, Cu, Sb, Al, In, Zn, Bi, Ge, Se, and Cd not only reduced tellurium dioxide at an adequate speed, but also produced a uniform sintered body, being likely to form a solid solution with the Te resulting from reduction. In particular, when Cu, Al, Sb, Pb and In were used, it was found that a solid solution with Te was easy to be formed so that an extremely uniform sintered body could be obtained.

The mixing ratio Xα of reducing substance was proper in a range of 15 mol% to 80 mol%, that is 15 mol%≤Xα≤80 mol %. When the mixing ratio is less than 15 mol%, reduction does not proceed sufficiently, and the [TeOx] thin film evaporated and deposited by using this sintered body was, as mentioned below, extremely high in oxygen O content, small in coefficient of light absorption, and insufficient in the optical change before and after recording. When the mixing ratio is over 80 mol%, reduction proceeds overly, and the [TeOx] thin film evaporated and deposited by using this sintered body was extremely high in Te content, unstable thermally, and was unusable as optical recording film. When the mixing ratio was somewhere between 15 mol% and 80 mol%, a sintered body of an appropriately advanced reduction of $TeO_2$ was obtained, and it was found that a [TeOx] thin film could be obtained as the principal material of the optical recording medium having characteristics corresponding to the mixing ratio by using it.

At this time, it is not necessary that the reducing substance be only one kind as mentioned above. For example, when n kinds of substances are used, supposing the individual mixing ratios to be X1, X2, ..., Xn mol%, the same discussion as raised above can be made by referring to the total content of

$$X\alpha=X1+X2+\ldots+Xn.$$

Fig. 3 shows a method of forming (TeOx) thin film by using the sintered body obtained as set forth above and vacuum deposition apparatus 36. The degree of vacuum in vacuum area 37 may be about $133.322\times10^{-3}$ Pa to $133.322\times10^{-7}$ Pa ($10^{-3}$ Torr to $10^{-7}$ Torr), and in particular a strong film with high adhesion is obtained at less than $133.322\times10^{-5}$ Pa ($10^{-5}$ Torr). For example, sintered body 38 obtained by the above heat treatment is put in a quartz tube 40, heated from outside by use of coil heater 42, and a [TeOx] thin film is formed on a board 46 placed on a support stand 44. An adequate heater temperature should be within the range of 500°C to 1,000°C, and vacuum deposition speed and film composition may be controlled within this range. The coil heater 42 is connected to an external power source 50 through an electrode 48 and is energized to heat.

The sintered body source 38 is made homogeneous by pulverizing the sintered body mass-produced in the heat treatment step and using various portions therefrom, so that the reproducibility may be enhanced.

As the heating method, aside from the heating of the entire surface from outside by using heater as mentioned above, it is also possible to heat locally and rapidly by using an electron beam. In this case, it is easier to heat pellets of disc form as shown in Fig. 4 obtained by compacting the pulverized sintered body as the source. For example, the size of the pellet is about 20 mm in diameter and 3 mm in thickness. But this size may be selected freely depending on the size of the board to be evaporated on and the thickness of thin film. The pellets are formed by using a jig 54 as shown in Fig. 5. The jig 54 includes an operation part 58 having a columnar pushing bar 56, a main body 62 having a circular hole 60 in which the pushing bar 56 is inserted, and a bottom 66 having a columnar protruding part 64 to close the lower end of the circular hole 60. A pulverized powder 68 of sintered body is put in this circular

hole 60, pressed, and compacted to be formed in shape. The heating method by use of electron beam was found to have the following advantages as compared with the heater method: (a) pellet temperature can suddenly and locally increase, so that the deviation of chemical composition is smaller than that by entire heating by heater, (b) response is rapid, and control of vacuum deposition speed is easy, and (c), as mentioned later, humidity resistance is improved. The film made by the method of using sintered body is, as compared with the film made by the other method, denser in the film structure and is less susceptible to ambient air, and the thin film heated by electron beam is considered to be further denser in film structure and practically free from effects of ambient air, so that humidity deterioration is estimated to be small.

A method of manufacturing an erasable [TeOx] ($0<x<2$) thin film is narrated below. An erasable material mainly made of TeOx was already proposed EP—A—0 121 426), and it was found that the following method could be applied to the composition of the material in this proposal and that a recording thin film of good reproducibility could be obtained. That method is one using as the vacuum deposition source the mixture body comprising the sintered body and additives obtained by using the same method as mixing of $TeO_2$ and reducing substance M explained above.

One of the features of this invention that it is easy to obtain a composition uniform in the film thicknesswise direction is particularly exhibited, relating to the additive to be added to the sintered body, when the vacuum deposition condition, for example, at the time of evaporating the additive is somewhat different from the vacuum deposition condition for obtaining a [TeOx] thin film by indirectly heating the sintered body alone.

That is, even if there is certain difference in the vacuum deposition condition between that of the [TeOx] components and that of additives, such troubles as isolation of the additive substance from [TeOx] components to be advanced in evaporation and remaining of the additive substance in the source so as not to be found in the finally obtained [TeOx] thin film do not occur, and a [TeOx] thin film containing additives at a desired concentration may be obtained.

This is derived from the characteristic that the O/Te ratio in the vacuum deposition film varies with the heating condition, especially evaporating rate, if the initial composition of sintered body is same, that is, the composition of sintered body can be selected according to the characteristics of the additive by making use of the characteristic that the oxygen O content increases when the evaporating rate is raised while the tellurium Te content increases when the evaporating rate is lowered: More specifically, in the case of Se, S, for example, when the vapor pressure of the additives is high, the mixture is formed by slightly increasing the oxygen content in the composition of sintered body, and a thin film is formed by lowering the evaporating rate. On the contrary, in the case of Au or Sn having a low vapor pressure, the mixture is formed by slightly increasing the tellurium Te content in the composition of sintered body, and a thin film is formed by raising the evaporating rate. In this process, [TeOx] thin films of different additives may be obtained at a same O/Te ratio.

As other factor, the mixture added to the sintered body possesses a certain mutual action with the Te in the sintered body in the heating process. For example, it may be considered that the mixture be melted to be mixed with Te before being evaporated, and evaporated as an alloy with Te so as to be dispersed uniformly in the film because vacuum deposition proceeds while keeping correlation with the Te vacuum deposition quantity. Anyway, since the mixture is evaporated uniformly in the [TeOx] thin film as it is mixed in the sintered body, this feature of the present invention is not varied by the above factor.

As the additives, metals, semimetals or nonmetal elements such as Ti, V, Ta, Cr, Mo, W, Mn, Fe, Co, Ni, Pt, Cu, Ag, Zn, Cd, Al, In, Tl, Si, Ge, Sn, Pb, As, Sb, Bi, S, Se, and Au may be used either alone or in the form of oxide, independently or as compound of substances. The content of the additives in the TeOx thin film is effective in a range of 0 to 50 mol% as mentioned, for example, in EP—A—0 121 426 or US—A—4 278 734, or more preferably, within the range of 10 to 30 mol%. In order to realize this, the optimum content β of additive in the vacuum deposition source should be within the range of 10 wt.% to 40 wt.%, i.e., $10 \leq \beta \leq 40$ wt.% though it is variable within this range depending on the material of additives, and vacuum deposition thin films with excellent recording characteristics and stability could be obtained in this range. The additive substance is, at the time of vacuum deposition as mentioned above, taken into the evaporated thin film and acts on the Te fine particles in the [TeOx] ($0<x<2$), and is bonded with Te, for example, as element monomer, so that fine Te particles may easily be formed on reversible phase transition. It may be also considered to exist in the vicinity of Te to serve to increase the coefficient of thermal diffusion (as disclosed in EP—A—0 121 426).

Among the additives mentioned above, in order to further enhance the uniformity of the evaporated film composition, to prevent the board from being damaged by lowering the evaporating temperature or satisfy other conditions, as the substance capable of being evaporated in the conditions close to the TeOx forming condition, materials having melting point and vapor pressure as close to either of those of Te or $TeO_2$ as possible should be selected. Materials having melting point and vapor pressure as close to those positioned between those of Te, $TeO_2$ could be selected, too. In this respect, Zn, Cd, In, Tl, Ge, Sn, Pb, As, Sb, Bi, S and Se were particularly effective. Above all, when Ge, Sn, Se, Bi, In, Zn were used, the vacuum deposition was easy and the recording characteristics of the obtained thin film were excellent.

When the content of these additives is selected within a range of 10 wt.% to 30 wt.%, the aforesaid content is achieved, and thin films particularly excelling in erasable property can be obtained (as disclosed in EP—A—0 121 426). At a higher content, however, the erasable property is sacrificed. On the contrary, if the content is too small, sufficient erasable property may not be obtained.

These additives may be used either alone or in the form of oxide, nitride, halide or carbide, but when added alone, the vacuum deposition was generally easier and reproducibility of characteristics was higher. However, in the tellurium compounds of these substance, as compared with those alone, the melting point and vapor pressure are very close to those of the [TeOx] (0<x<2) compound evaporated from the sintered body of the principal material, and a vacuum deposition source excelling in stability and reproducibility may be obtained. As a result, vacuum deposition thin film obtained from this source was found to be homogeneous in the composition of film as compared with the film obtained by using the additive substance alone. Besides, the substances which are somewhat hard to use alone have been found to be sufficiently usable when bonded with tellurium. For instance, the following compounds are usable: Ti-Te, V-Te, Ta-Te, Cr-Te, Mo-Te, W-Te, Mn-Te, Fe-Te, Co-Te, Ni-Te, Pt-Te, Cu-Te, Ag-Te, Zn-Te, Cd-Te, Al-Te, In-Te, Tl-Te, Si-Te, Ge-Te, Sn-Te, Pb-Te, As-Te, Sb-Te, Bi-Te, S-Te, Se-Te, Au-Te. Above all, when Te compounds such as Ge-Te, Sn-Te, In-Te, Pb-Te, Sb-Te, Se-Te, Zn-Te, Al-Te, Bi-Te, Cu-Te and Au-Te were used either alone or in combination, vacuum deposition thin films of extremely excellent recording and erasing properties were obtained.

These Te compounds may be used also in combination of aforesaid single elements or compounds thereof. For example, vacuum deposition sources combining Ge with Sn-Te, In-Te, Pb-Te, Sb-Te, Se-Te, Zn-Te, Al-Te, Bi-Te, Cu-Te, Au-Te, etc. were found to produce erasable optical recording thin films extremely excellent in stability, reproducibility and characteristics.

In the composition of the mixture the ratio by weight of the additive should be preferably 10 wt.% to 40 wt.%. When a tellurium compound was used, erasable vacuum deposition films were obtained in a relatively wide range of content, and the characteristics were not significantly changed if the content is small, and this method was found to be extremely effective for enhancing the reproducibility.

The role of Ge to raise the crystallization temperature of Te in [TeOx] (0<x<2) thin film and to enhance the thermal stability of film was already proposed (for example, as disclosed in the Proceedings of 1983 Japan Display, p. 46). At the same time, Ge added together with tellurium compound to the sintered body was found to be contained in the film at good reproducibility, at a concentration according to the concentration of addition. For example, when Ge is used together with Sn-Te, In-Te, Pb-Te, Sb-Te, Se-Te, Zn-Te, Al-Te, Bi-Te, Cu-Te, Au-Te, etc., stable recording thin films were obtained at good reproducibility when the Ge content β was in a range of 0 to 10 wt.%, that is, $0 \leq \beta \leq 10$ wt.%, or the content of about 0 to 10 mol% in the film. When the addition of Ge exceeded 10%, it was difficult to crystallize the film at a short pulse.

The method of forming a (TeOx) thin film containing the additives by using thus obtained mixture vacuum deposition source is applicable to the same system as shown in Fig. 3. The degree of vacuum of vacuum area 37 may be about $133.322 \times 10^{-3}$ Pa to $133.322 \times 10^{-7}$ Pa ($10^{-3}$ Torr to $10^{-7}$ Torr), and in particular below $133.322 \times 10^{-5}$ Pa ($10^{-5}$ Torr), a strong film of high adhesion is obtained. For example, the mixture is put in a quartz container 40 and heated from outside by a coil heater 42, and a thin film of [TeOx] containing the additive substance is evaporated and formed on a board 46 placed on a support stand 44. A proper heater temperature is somewhere between 500°C and 1,000°C, and the evaporating speed and film composition may be controlled in this range. The coil heater 42 is connected to an external power source 50 through electrodes 48, and is energized to heat.

The mixture vacuum deposition source, which is prepared by producing a large quantity of mixture and dispensed by necessary portions, is homogeneous, and contributes to enhancement of reproducibility.

By annealing the mixture in an inert gas of $N_2$, Ar or the like, affinity among components is improved, and sudden boiling in vacuum deposition or other accident may be eliminated. However, if the annealing temperature exceeds the sintering temperature of the main material, the characteristics of the sintered body are varied. Therefore, the annealing temperature should be set somewhat lower than the sintering temperature.

As the method of heating at the time of vacuum deposition, aside from the method of heating the entire surface from outside by using a heater as mentioned above, it is also possible to heat locally and quickly by using an electron beam. In this case, it is easier to heat by using the source in pellet form, for example as shown in Fig. 4, by compacting the powder of mixture body and forming into disc shape. As compared with the heater method, the electron beam method has been found to bring about the following advantages: (a) it is also possible to elevate the pellet temperature suddenly and locally, and the deviation in composition is smaller than that in heater method, (b) since the response is quick, it is easier to control the evaporating speed, and (c) as mentioned later, humidity resistance is improved. The film made by a method of using the sintered body as main material is denser in the film structure than the film made by other methods, and is therefore considered to be less susceptible to ambient air. What is more, the thin film heated

by electron beam is further denser and more homogeneous in the film structure, and is practically free from effects of ambient air, so that the deterioration by humidity is considered to be small.

The present invention is further described below by referring to the embodiments.

Embodiment 1

Using $TeO_2$ powder and Cu powder as the starting materials, 111.72 gram of $TeO_2$ (about 0.7 mol) and 19.68 gram of Cu (about 0.3 mol) were mixed together with a small quantity of alcohol according to a method as mentioned above. A hundred grams of thus obtained mixture powder was put on a quartz boat and heated in an electric furnace. A specimen was put in a furnace core tube, and while passing $N_2$ gas at a rate of about 2 liters/hour, the furnace temperature was raised to reach 700°C in about 30 minutes. After holding the state for about two hours, the specimen was drawn out to the low temperature zone of the furnace to be cooled. About an hour later, when the specimen was taken out of the furnace, a dark brown glass-like solid material, that is, a sintered body was obtained.

This solid material was taken out of the quartz boat, and part of it was evaporated in a vacuum deposition apparatus as shown in Fig. 3. At a degree of vacuum of $133.10^{-5}$ Pa ($1\times10^{-5}$ Torr) and heater temperature of 700°C, about 200 mg of a small lump of the sintered body was put in a quartz container and heated. As a result, a slightly yellowish brown transparent [TeOx] thin film was formed on an acrylic resin board in a thickness of about 1,200 Å. When this thin film was irradiated with a semiconductor laser beam of wavelength (λ) of 830 nm focusing through an optical system as shown in Fig. 7, the illuminated part was found to be darkened.

Embodiment 2

In embodiment 1, as a result of similar experiment by varying the mixing ratio α of Cu to the $TeO_2$ powder in a range of 0 to 100 mol% at 5 mol% increments, dark brown uniform sintered bodies were obtained in a mixing ratio range of 0 to 90 mol%. When these sintered bodies were evaporated similarly as in Embodiment 1, when the mixing ratio α was in a range of 0 to 15 mol%, i.e., $0\leq\alpha\leq15$ mol%, the optical density of the obtained thin films was extremely small, and notable density change was not obtained by irradiation with semiconductor laser beam. When the mixing ratio α was over 80 mol%, i.e., $\alpha>80$ mol%, the optical density increased, but the film was unstable, and the evaporated part was a brown transparent film but shortly changed at room temperature until becoming an opaque, slightly metallic, black film. When the mixing ratio α was within the range of 15 mol% to 80 mol%, i.e., $15\leq\alpha\leq80$ mol%, a stable yellowish brown transparent film was obtained, and it was darkened when irradiated with a semiconductor laser beam.

As a result of composition analysis by use of Auger electron spectral method, the deviation of composition in the film thicknesswise direction was practically none and the composition was homogeneous, and it was found that the O/Te value decreased in the direction of high mixing ratio as shown in Fig. 10.

Embodiment 3

As a result of similar experiment in a mixing ratio range of 0 to 100 mol% by using Al instead of Cu used in Embodiment 1, black sintered bodies were obtained in the mixing ratio range of 10 mol% to 80 mol%. When these sintered bodies were similarly evaporated as in Embodiment 1, the optical density of obtained thin films was extremely small in the mixing ratio range of 0 to 20 mol%, and notable density change was not obtained by irradiation with semiconductor laser beam. When the mixing ratio was over 60 mol%, the optical density was raised, but the film was unstable and changed from dark to black color at room temperature. When the mixing ratio α was in a range of 20 mol% to 60 mol%, i.e., 20 mol%$\leq\alpha\leq$60 mol%, stable yellowish brown films were obtained, and they were darkened when irradiated with semiconductor laser beam. As a result of analysis of composition by Auger electron spectral method, it was found that the O/Te ratio varied sensibly to the addition concentration of Al.

Embodiment 4

Instead of Cu powder, Al, Si, Ti, V, Cd, In, Sn, Sb, Ta, W, Cr, Mn, Fe, Co, Ni, Zn, Ge, Mo, S, Se, and C powder were used, and individual sintered bodies were obtained in the experiment conforming to Embodiments 1 and 2. Among them, when Sb, Pb, Al, In, Zn, Bi, Ge, Se, and Cd were used, glass-like homogeneous sintered bodies with black, yellowish brown, black, dark brown, black, grayish brown, yellowish brown, reddish brown, and grayish brown colors were obtained respectively. When Al, Sb, Pb, In were used, homogeneous glass-like sintered bodies were obtained in a wide range of mixing ratio, like the case where Cu was used. But when Si, C, Mn were used, slightly nonhomogeneous sintered bodies were obtained.

These sintered bodies were heated in a vacuum, and thin films of [TeOx] ($0<x<2$) were obtained individually.

Embodiment 5

Next, by using plural reducing substances M, a method to control the characteristics of [TeOx] thin film finely was studied. The reducing substances mentioned in Embodiment 4 are not identical in reducing ability, but are divided into those which are oxidized and react violently with a relatively high reducing ability such as $MO_2$ and $M_2O_3$, and others which are slightly oxidized and react mildly with a relatively low reducing ability such as MO and $M_2O$. Therefore, by combining these two types, it is possible to control finely. As a result of Embodiment 4, it was found easy to

use particularly Al and Cu as the representatives of the former group and latter group, respectively.

Accordingly, by mixing Al and Cu to $TeO_2$ at various mixing ratios, the mixture was heated for 2 hours at 700°C in $N_2$ gas atmosphere, and dark brown sintered bodies were obtained. Using 200 mg of each sintered body, as a result of heating in a vacuum of $133.10^{-5}$ Pa ($10^{-5}$ Torr) by heater, films with characteristics corresponding to slight changes in the mixing ratio were obtained. The results was further examined by irradiating with semiconductor laser, and thin films particularly suited to recording characteristics of optical information were obtained at the Al mixing ratio $\alpha_1$ and Cu mixing ratio $\alpha_2$ of 15 mol%$\leq\alpha_1\leq$50 mol% and 20 mol%$\leq\alpha_2\leq$60 mol%, or, when the two elements are mixed at the same time, 50 mol%$\leq\alpha_1+\alpha_2\leq$80 mol%.

Embodiment 6

Among the sintered bodies obtained in Embodiment 5, a product of which starting composition was $(TeO_2)_{30}(Al)_{30}(Cu)_{40}$ mol% was selected, and pulverized into powder form. About 2 gram of this powder was weighed, and pressed and shaped into a pellet measuring 20 mm in diameter and about 1.5 mm in thickness by use of a press jig as shown in Fig. 5. The press pressure was 5 tons/cm$^2$.

When a thin film was evaporated and deposited on a pyrex® board by use of the pellet by heating with a heater in a system as shown in Fig. 3 in one method and by heating with an electron beam in another method, slightly yellowish brown thin films of [TeOx] were obtained. When these two films were put in a thermostatic oven controlled at 50°C and 90% relative humidity and changes in the transmission were measured at regular intervals, curb b of the thin film heated by electron beam was smaller in changes than curb a of the thin film heated by heater as shown in Fig. 6, and the former film was found to be less susceptible to humidity and much stabler.

Embodiment 7

An optical disk was experimentally formed on a PMMA (polymethylmethacrylate) resin board of 1.1 mm in thickness and 200 mm in diameter rotating at a speed of 150 rpm by evaporating and depositing a thin film of [TeOx] ($0<x<2$) having a thickness of about 1,200 Å at a speed of 3 Å/sec, by using a pellet of which starting composition is $(TeO_2)_{30}(Al)_{30}(Cu)_{40}$ in an electron beam heating system as used in Embodiment 6.

Using this disk, a test recording was conducted in a system as shown in Fig. 7. The light 72 leaving the semiconductor laser 70 was changed to a quasi-parallel light 76 by a first lens 74, shaped in a round shape by a second lens 78, and returned to a parallel light by a third lens 80, and was converged into a spot light of wavelength limit of about 0.8 µm by a fourth lens 84 by way of a half mirror 82. The recording film on the disk 88 irradiated with this circular spot light is darkened to record information. Thus, by modulating the semiconductor laser, information signals can be recorded on the disk.

Photosensitive diode 96 detected the signals by receiving the reflected light 90 from the disk surface 88 through a half mirror 92 and a lens 94.

When the semiconductor laser was modulated at a single frequency of 5 MHz and the disk surface rotating in the direction of 98 at a speed of 1800 rpm was irradiated with the laser beam having an irradiating power of 8 mW, the information was recorded. The C/N ratio was measured by use of a spectral analyzer, and 60 dB was obtained.

Embodiment 8

The powder that was obtained by pulverizing the solid material produced in Embodiment 1, and Sn powder were mixed at the ratio by weight of 0, 5, 10, 20, 30, 40, and 50%, and the thin film was evaporated and deposited by use of the mixture in a system shown in Fig. 1. At the degree of vacuum of $133.322\times10^{-5}$ Pa ($1\times10^{-5}$ Torr) and heater temperature of 750°C, each powder of 300 mg was put in a quartz tube and heated, and yellowish brown transparent thin films were formed on a acrylic resin board in a film thickness of 800 Å to 1,200 Å. When the thin film was irradiated with a semiconductor beam with wavelength of 830 nm for 1 µsec as a weak light of about 1 mW/µm$^2$ by converging slightly off focus through an optical system, it was darkened. Using the same semiconductor laser beam, when the darkened area was reirradiated on focus for about 50 µsec at a high intensity of about 5 mW/µ$^2$, the darkened area returned to the original yellowish brown color in the film whose Sn content was in a range of 5 wt.% to 40 wt.%. However, if the Sn content was less than 5 wt.%, the film did not return to the original state completely, and if the content was over 40 wt.%, there was no reversibility at all.

As a result of close examinations of transmission and reflectivity of the films after recovery reversible changes were repetitively observed in the Sn content $\beta$ having range of 10 wt.%, to 30 wt.%, i.e., 10 wt.%$\leq\beta\leq$30 wt.%.

Embodiment 9

Among the sintered bodies obtained in Embodiment 5, those whose starting compositions was $(TeO_2)_{30}(Al)_{30}(Cu)_{40}$ mol% were selected, and pulverized to fine powder. The powder was mixed with Ti, V, Ta, Cr, Mo, W, Mn, Fe, Ni, Pt, Cu, Ag, Zn, Cd, Al, In, Tl, Si, Ge, Sn, Pb, As, Sb, Bi, S, and Se as additives either alone or in the form of oxide in a range of 0 to 50 wt.% at 5 wt.% increments, and a same experiment as in Embodiment 2 was conducted. As a result, erasable yellowish brown thin films were obtained in the content range $\beta$ of 10 wt.% to 40 wt.% (10 wt.%$\leq\beta\leq$40 wt.%) in the case of independent additives, or 20 wt.% to 60 wt.% (20 wt.%$\leq\beta\leq$60 wt.%) in the case of oxides. Above all, when Zn, Cd, In, Tl, Ge, Sn, Pb, As, Sb, Bi, S, and Se were used alone, the affinity for the sintered body, the

main material of the source, was good, and a uniform vacuum deposition film was obtained at a low heater temperature at the time of vacuum deposition. In particular, when using the vacuum deposition source mixing with Ge, Sn, Bi, In, Zn, the heater temperature was sufficient at 400°C to 700°C, and vacuum deposition at high reproducibility could be performed easily. When the additive content β was in a range of 10 wt.% to 30 wt.% (10 wt.%≤β≤30 wt.%), thin films particularly excelling in repetitive characteristics were obtained.

On the contrary, when elements of relatively low vapor pressure such as Ti, Fe, Co, Ta, Ni, Pt, W, and Cr were used, it was difficult to form a uniform film evenly mixed with the predominant sintered body.

Embodiment 10

As the additives, tellurium compounds of various elements were studied. As the sintered bodies, those whose starting composition was $(TeO_2)_{30}(Al)_{30}(Cu)_{40}$ mol% were used by sintering in the same method as that in Embodiment 1.

As the tellurium compound, TeSn was used, and was mixed well with the sintered body at mixing ratio α of 0 to 50 wt.% (0<α<50 wt.%). About 2 gram of this powder was weighed, and was pressed and formed into a pellet measuring 20 mm in diameter and about 1.5 mm in thickness by using press jig. The press pressure was 5 tons/$cm^2$. When this pellet was heated in a vacuum of $133.322\times10^{-5}$ Pa ($1\times10^{-5}$ Torr) in a system as shown in Fig. 3 with an electron beam of 5 kW output, a very homogeneous thin film was formed on an acrylic resin board in a thickness of about 1,000 Å at a speed of 10 Å/second. When the characteristics of this thin film were measured by varying the power of illuminating light and irradiation time by use of semiconductor laser and optical system, thin films of extremely good repetitive performance were obtained in a wide range of additive content β of 10 wt.% to 40 wt.% (10 wt.%≤β≤40 wt.%). When the content was below 10%, a sufficient erasable characteristic was not obtained, and when it was over 40%, a film of an extremely Te content was obtained, which was found to be lowered in the stability.

Embodiment 11

When a same experiment as in Embodiment 10 was conducted by using Ge-Te, S-Te, In-Te, Pb-Te, Sb-Te, Se-Te, Zn-Te, Al-Te, Bi-Te, and Cu-Te as tellurium compounds, vacuum deposition sources which are easy to evaporate, good in reproducibility, and capable of producing erasable films were obtained also in the same addition density range of 10 wt.% to 40 wt.%.

Embodiment 12

Difference in characteristics due to difference in heating method was observed. In Embodiment 10, the mixing ratio of TeSn was selected at 20 wt.%, and the mixture was heated by a heater as shown in Fig. 3 in one method and by an electron beam in other method. As a result, apparently identical slightly dark thin films were evaporated and deposited on a Pyrex® board. When these two films wer put in a thermostatic oven controlled at 50°C and 90% relative humidity and changes in the transmission were measured at regular intervals, it was found, as shown in Fig. 6, that film b by electron beam heating was smaller in changes less susceptible to humidity, and stabler than film a by heater heating.

Next, by using plural additive substances, a method to control finely the characteristics of the recording thin film mainly composed of $[TeO_x]$ to be obtained was studied. The additives mentioned in Embodiments 9, 11, etc. were not constant in the vacuum deposition characteristics or behavior in the film. For instance, there were certain substances which act to raise the phase transition temperature, and others which act to shorten the irradiation time required for phase transition.

Embodiment 13

Using Sn-Te as the component to enhance the erasing function, and Ge as the component to promote the stability of film, vacuum deposition was performed in the same method as in Embodiment 9 by varying the content of each additive, and erasable and stable thin films were obtained in the additive content having range of 10 wt.% to 40 wt.% (10 wt.%≤β≤40 wt.%). In particular, in a range of 15 wt.% to 30 wt.% (15. wt.%≤β≤30 wt.%), the repetitive performance was very good, and recording and erasing of 100,000 times was confirmed.

Fig. 8 shows the changes in the darkening temperature at various contents of Ge with the TeSn content fixed at 20 wt.%. When the Ge content was 8 wt.%, the transition temperature shifted to a considerably high 200°C and a large laser power was required, and when it was 10 wt.%, the tempertaure climbed higher to 240°C, and the transition was difficult in a film containing more Ge.

Embodiment 14

The SnTe used in Embodiment 13 was replaced by InTe, PbTe, $Sb_2Te_3$, SeTe, ZnTe, $Al_2Te_3$, $Bi_2Te_3$, and $Cu_2Te$, and vacuum deposition was performed. As a result, same effects were obtained as those in Embodiment 13.

Embodiment 15

Employing this vacuum deposition method, a disk for optical recording was experimentally produced. Recording and erasing was tested in a system as shown in Fig. 9. First, when a disk surface 100 rotating at a speed of 1,800 rpm was irradiated with the light of semiconductor laser 102 by a laser spot light 110 defined in the half-value intensity distribution of 10 μm in the disk rotating direction and 1 μm in the radial direction in a total power of 10 mW by use of lens system 104, mirror 106 and lens 108, the illuminated area was darkened, and a black track 112 was formed.

Next, the light of other semiconductor laser 122 was converged into a circular spot light 124 of 0.8 µm reduced to the limit of its wavelength 830 nm through other lens system 114, mirror 116, half mirror 118, and lens 120. While modulating this laser spot light 124 at a single frequency of 5 MHz, the obtained black track 112 was irradiated with the light having total power of 8 mW, and the illuminated area returned to the original state, and a bit group 126 by recording of signals was formed.

For detection of signal, the reflected light 128 from the disk was focused by a lens system 130 for reproduction, and was fed into a detector 132 to be read. When the C/N was measured by using a spectral analyzer, 58 dB was obtained.

Then, irradiating with the first slender laser spot light 110, the recorded bit 126 was erased, and no signal could be detected by spectral analyzer.

**Claims**

1. A method of producing an optical recording medium, which comprises the steps of:

(a) heat treating a mixture of tellurium dioxide and a reducing agent M so as to cause reaction of said tellurium dioxide with said reducing agent and production of a sintered body, and

(b) producing an optical recording layer comprising a tellurium compound on a substrate by vacuum deposition using said sintered body or a body obtained therefrom as the evaporation source.

2. A method according to claim 1, in which M is at least one of Cu, Al, Sb, Pb and In.

3. A method according to claims 1 or 2, in which M constitutes 15 to 80 mole % of said mixture.

4. A method according to claim 2, in which M is Cu in an amount of 15 to 80 mole % of said mixture or Al in an amount of 20 to 60 mole % of said mixture.

5. A method according to claim 2, in which M is a mixture of Cu and Al, which are preferably mixed simultaneously, preferably in an amount such that Al is present as 15 to 50 mole % of said mixture, Cu is present in an amount of 20 to 60 mole % of said mixture, and the total amount of Al plus Cu is 50 to 80 mole % of said mixture.

6. A method according to any of claims 1 to 5, in which the sintered body obtained in step (a) is mixed, prior to step (b), with an erasability-enhancing additive, preferably in an amount of 10 to 40% by weight of the mixture.

7. A method according to claim 6, in which said additive is at least one of Ge, Sn, Se, Bi, In and Zn, and/or telluride.

8. A method according to claim 7, in which the telluride is at least one telluride of Sn, In, Pb, Sb, Se, Zn, Al, Bi, Cu or Au, optionally together with Ge.

9. A method according to claim 8, in which the Ge is present in an amount of up to 10% by weight.

10. A method according to claim 1, comprising (a) mixing at least one reducing element M selected from Al, Si, Ti, V, W, Cr, Mn, Fe, Co, Ni, Cu, Zn, Ge, Mo, Cd, In, Sn, Sb, Ta, Bi, Pb, S, Se and C with tellurium dioxide and heating to form sintered $(TeO_2)_{100-x\alpha}M_{x\alpha}$ ($0<x\alpha<80$ mole %) and optionally, an erasibility-enhancing additive, and (b) heating the sintered material in a vacuum and forming a tellurium compound thin film on a board as an optical recording medium.

11. A method according to any of claims 1 to 10, in which the sintered body obtained following step (a) is pulverised, pressed and formed to obtain a body used as said evaporation source.

**Patentansprüche**

1. Verfahren zur Herstellung eines optischen Aufzeichnungsmediums umfassend die Stufen:

(a) Wärmebehandeln einer Mischung aus Tellurdioxid und einem Reduktionsmittel M, um eine Reaktion des Tellurdioxids mit dem Reduktionsmittel und die Erzeugung eines gesinterten Körpers zu bewirken und

(b) Herstellen einer optischen Aufzeichnungsschicht, umfassend eine Tellurverbindung auf einem Substrat mittels Vakuumabscheidung unter Verwendung des gesinterten Körpers oder eines daraus erhaltenen Körpers als Verdampfungsquelle.

2. Verfahren nach Anspruch 1, wobei M mindestens eines von Cu, Al, Sb, Pb und In ist.

3. Verfahren nach Anspruch 1 oder 2, wobei M 15 bis 80 Mol-% der Mischung ausmacht.

4. Verfahren nach Anspruch 2, wobei M Cu in einer Menge von 15 bis 80 Mol-% der Mischung oder Al in einer Menge von 20 bis 60 Mol-% der Mischung ist.

5. Verfahren nach Anspruch 2, wobei M eine Mischung aus Cu und Al, die vorzugsweise gleichzeitig gemischt werden, ist, vorzugsweise in einer solchen Menge, daß Al zu 15 bis 50 Mol-% der Mischung, Cu in einer Menge von 20 bis 60 Mol-% der Mischung vorliegt und die gesamte Menge an Al plus Cu 50 bis 80 Mol-% der Mischung beträgt.

6. Verfahren nach mindestens einem der Ansprüche 1 bis 5, wobei der in Stufe (a) erhaltene, gesinterte Körper vor der Stufe (b) mit einem die Löschbarkeit verstärkenden Additiv, vorzugsweise in einer Menge von 10 bis 40 Gew.-% der Mischung, gemischt wird.

7. Verfahren nach Anspruch 6, wobei das Additiv mindestens einers von Ge, Sn, Se, Bi, In und Zn und/oder Tellurid ist.

8. Verfahren nach Anspruch 7, wobei das Tellurid wenigstens ein Tellurid von Sn, In, Pb, Sb, Se, Zn, Al, Bi, Cu oder Au, wahlweise zusammen mit Ge, ist.

9. Verfahren nach Anspruch 8, wobei das Ge in einer Menge von bis zu 10 Gew.-% vorliegt.

10. Verfahren nach Anspruch 1, umfassend das

(a) Vermischen wenigstens eines reduzierenden Elements M, gewählt aus Al, Si, Ti, V, W, Cr, Mn, Fe, Co, Ni, Cu, Zn, Ge, Mo, Cd, In, Sn, Sb, Ta, Bi, Pb, S, Se und C mit Tellurdioxid und Erhitzen, zur Bildung von gesintertem $(TeO_2)_{100-x\alpha}M_{x\alpha}$ ($0<x\alpha<80$ Mol-%) und wahlweise einem die Löschbarkeit verstärkenden Additiv und

(b) Erhitzen des gesinterten Materials in einem Vakuum und Ausbilden eines dünnen Films aus einer Tellurverbindung auf einer Platte als optisches Aufzeichnungsmedium.

11. Verfahren nach wenigstens einem der Ansprüche 1 bis 10, wobei der bei Durchführung der Stufe (a) erhaltene, gesinterte Körper pulverisiert, gepreßt und geformt wird, um einen Körper zu erhalten, der als Verdampfungsquelle verwendet wird.

**Revendications**

1. Une méthode de production d'un milieu d'enregistrement optique, comprenant les étapes suivantes:

(a) traitement thermique d'un mélange de bioxyde de tellure et d'un agent réducteur M pour provoquer la réaction dudit bioxyde de tellure avec cet agent réducteur et produire un corps fritté, et

(b) production d'une couche d'enregistrement optique comprenant un composé de tellure sur un substrat par dépôt sous vide utilisant ledit corps fritté ou un corps obtenu à partir de ce dernier en tant que source d'évaporation.

2. Une méthode selon la revendication 1, selon laquelle M est au moins l'un des éléments Cu, Al, Sb, Pb et In.

3. Une méthode selon la revendication 1 ou 2, selon laquelle M constitue 15 à 80% molaire dudit mélange.

4. Une méthode selon la revendication 2, selon laquelle M est du Cu en quantité de 15 à 80% molaire dudit mélange ou du Al en quantité de 20 à 60% molaire dudit mélange.

5. Une méthode selon la revendication 2, selon laquelle M est un mélange de Cu et de Al, qui sont de préférence mélangés simultanément, de préférence en quantité telle que Al soit présent à raison de 15 à 50% molaire dudit mélange et que Cu soit présent en quantité de 20 à 60% molaire dudit mélange, et que la quantité totale de Al plus Cu soit de 50 à 80% molaire dudit mélange.

6. Une méthode selon l'une quelconque des revendications 1 à 5, selon laquelle le corps fritté obtenu dans l'étape (a) est mélangé, avant l'étape (b), avec un additif améliorant l'effaçabilité, de préférence en quantité de 10 à 40% en poids du mélange.

7. Une méthode selon la revendication 6, selon laquelle ledit additif est l'un au moins des éléments Ge, Sn, Se, Bi, In et Zn, et/ou un tellurure.

8. Une méthode selon la revendication 7, selon laquelle le tellurure est au moins un tellurure de Sn, In, Pb, Sb, Se, Zn, Al, Bi, Cu ou Au, éventuellement ensemble avec Ge.

9. Une méthode selon la revendication 8, selon laquelle le Ge est présent en quantité atteignant 10% en poids.

10. Une méthode selon la revendication 1, comprenant:

(a) le mélange d'au moins un élément réducteur M choisi parmi Al, Si, Ti, V, W, Cr, Mn, Fe, Co, Ni, Cu, Zn, Ge, Mo, Cd, In, Sn, Sb, Ta, Bi, Pb, S, Se et C avec le bioxyde de tellure et le chauffage pour former du $(TeO_2)_{100-x\alpha}M_{x\alpha}$ ($0<x\alpha<80$% molaire) fritté et éventuellement un additif améliorant l'effaçabilité, et

(b) le chauffage de la matière frittée sous vide et la formation d'un film mince de composé de tellure sur un panneau en tant qu'un milieu d'enregistrement optique.

11. Une méthode selon l'une quelconque des revendications 1 à 10, selon laquelle le corps fritté obtenu après l'étape (a) est pulvérisé, pressé, et mis en forme pour obtenir un corps utilisé comme ladite source d'évaporation.

FIG. 1

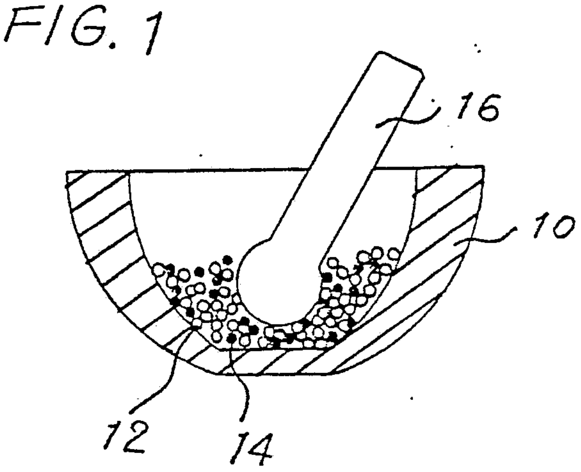


FIG. 2

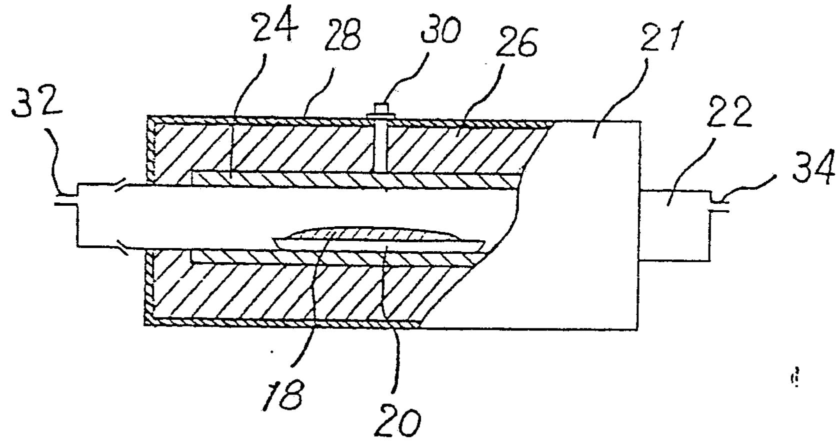

FIG. 3

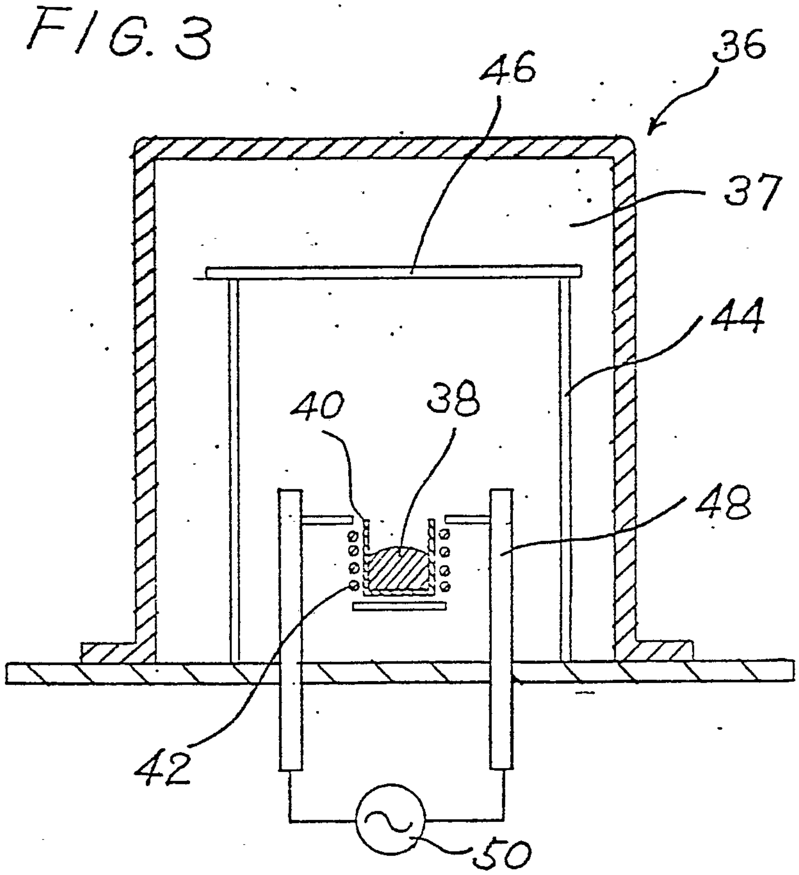
46
36
37
44
40
38
48
42
50

FIG. 6

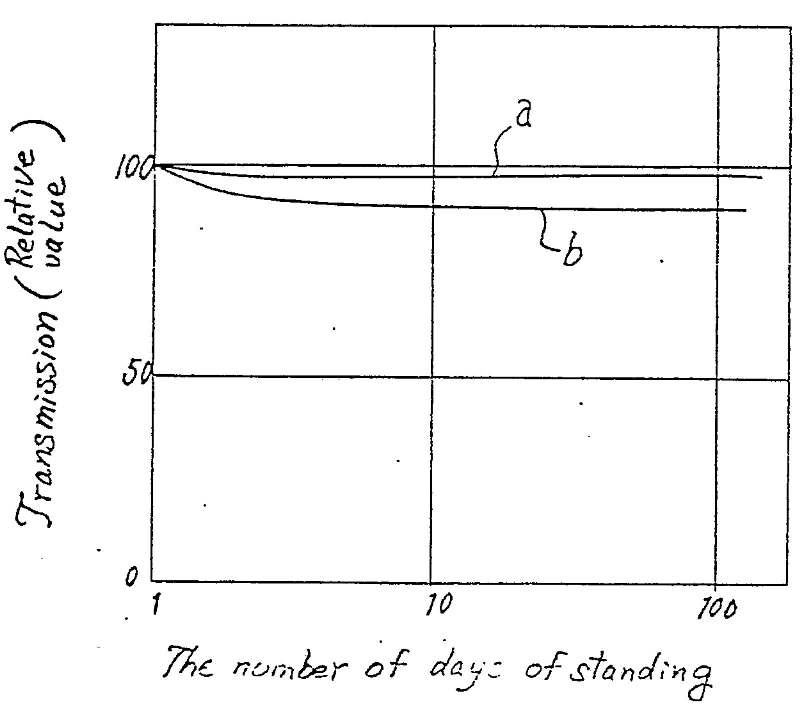
Transmission (Relative value)
100
50
0
a
b
1
10
100
The number of days of standing

FIG. 4

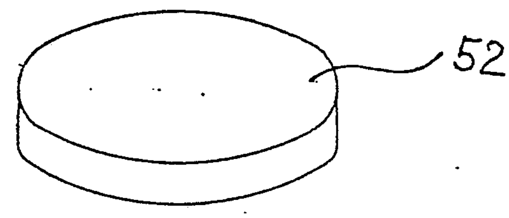


FIG. 5

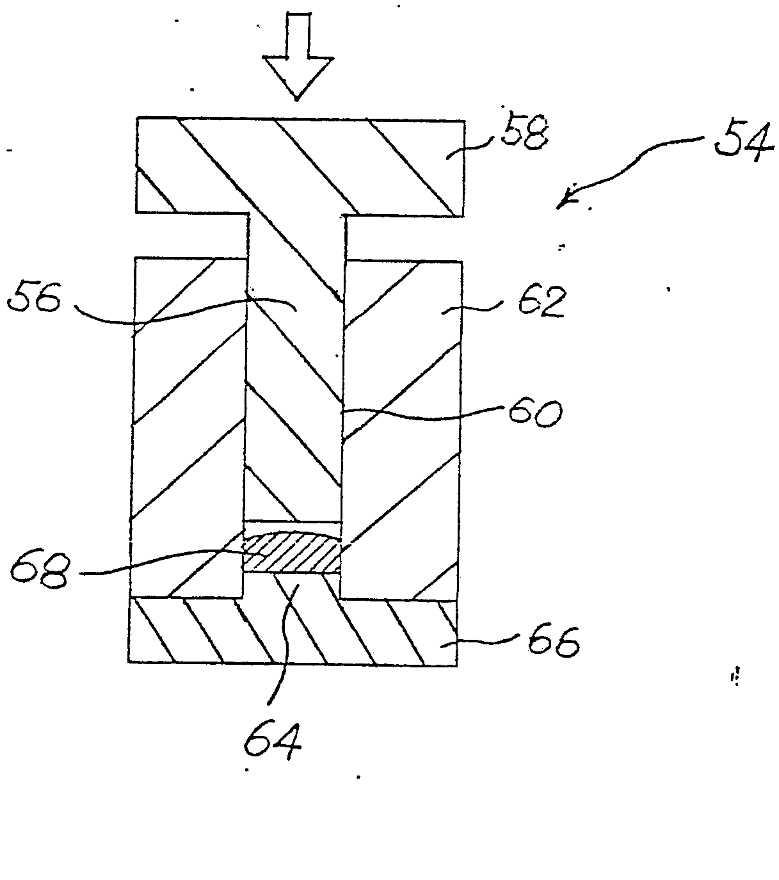

FIG.7

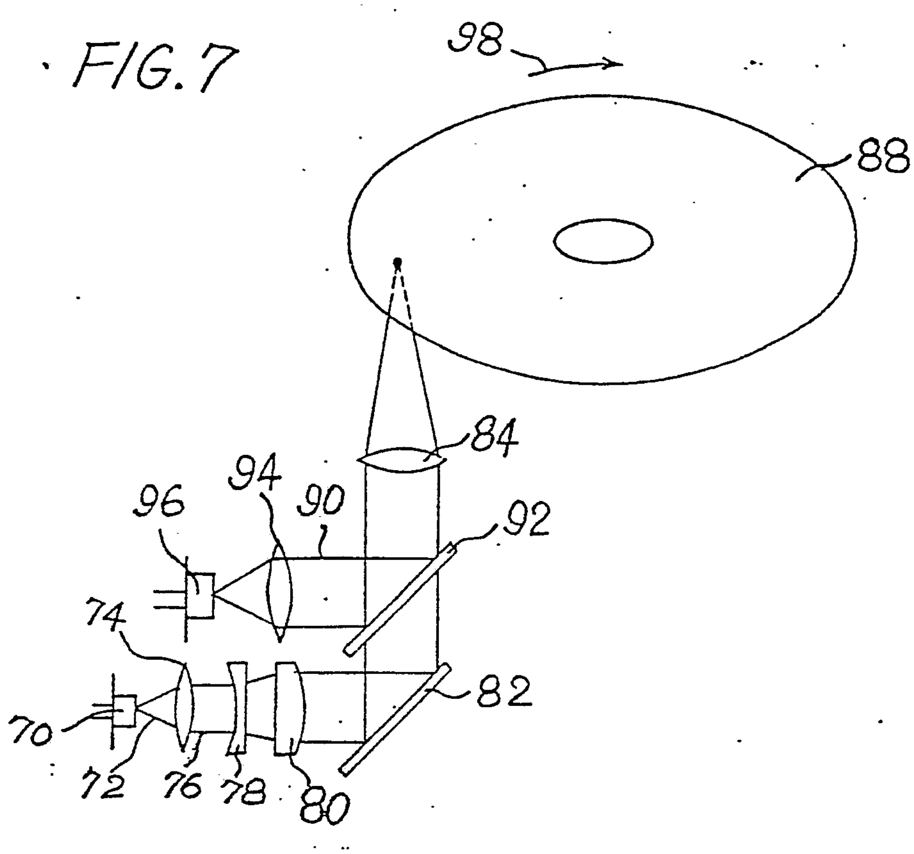
98
88
84
94
90
96
92
74
82
70
72
76
78
80

FIG.8

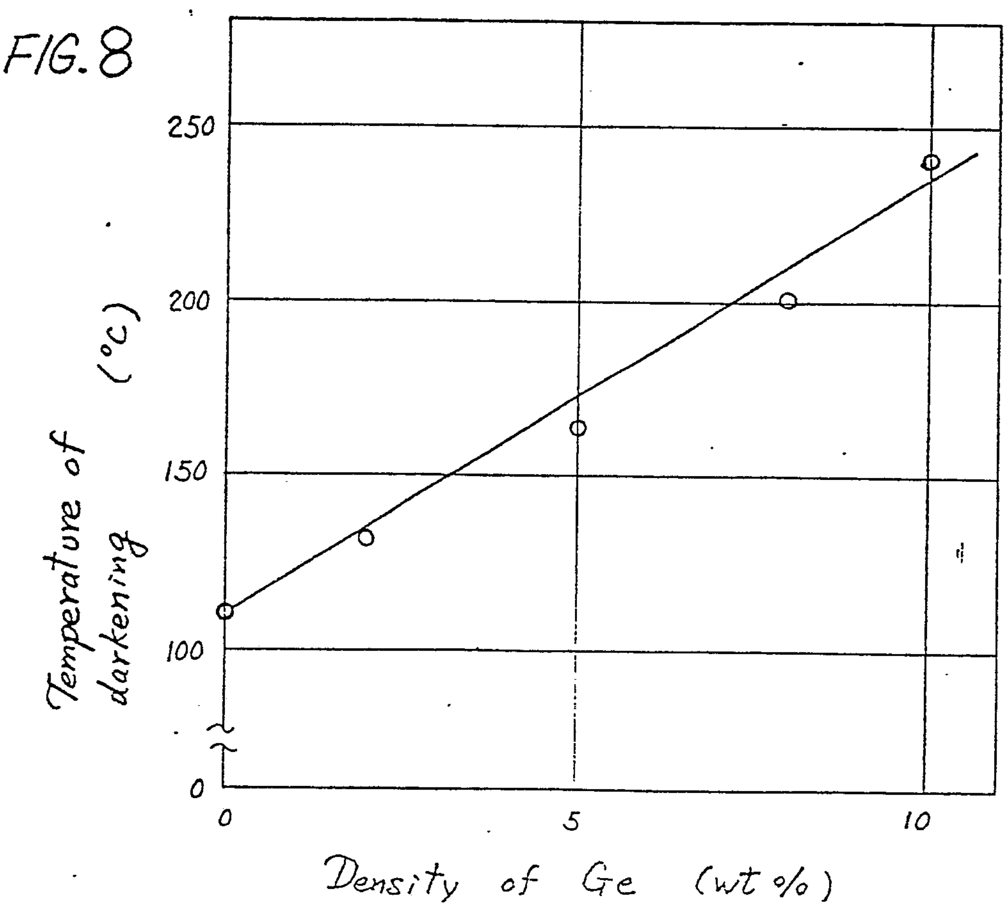
250
200
150
100
0
0
5
10
Temperature of darkening (°C)
Density of Ge (wt %)

FIG. 9

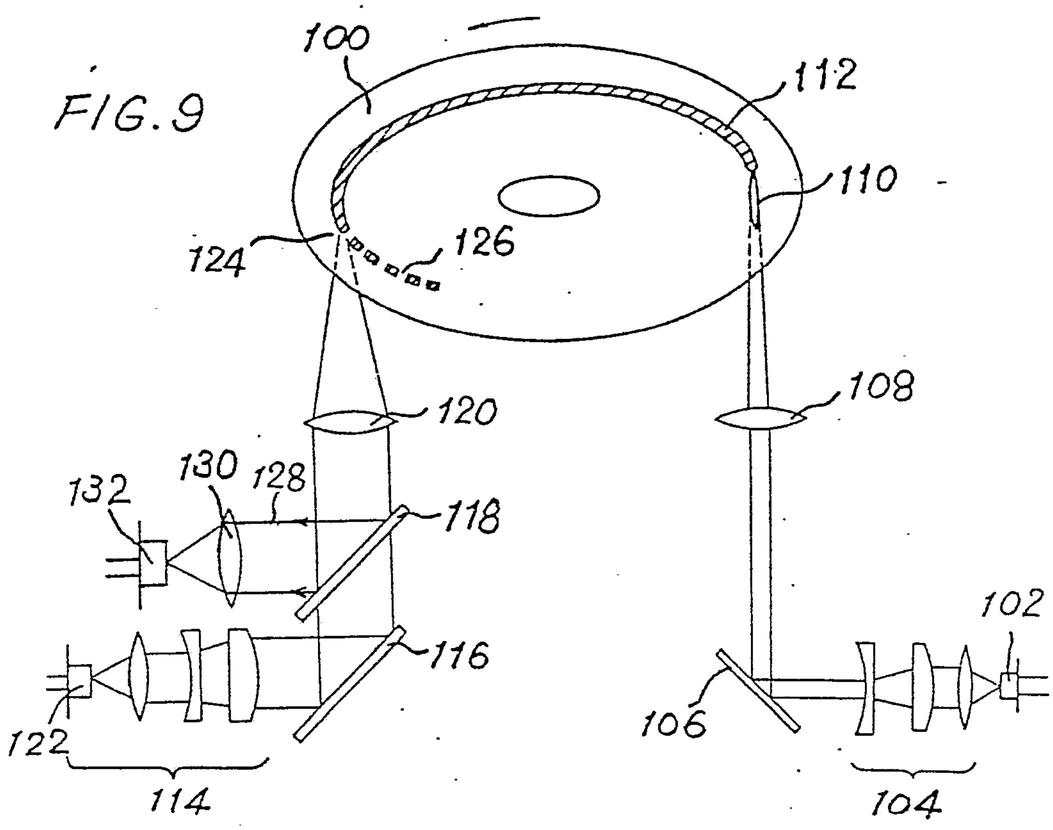
100
112
110
124
126
108
120
132
130
128
118
116
102
106
122
114
104

FIG. 10

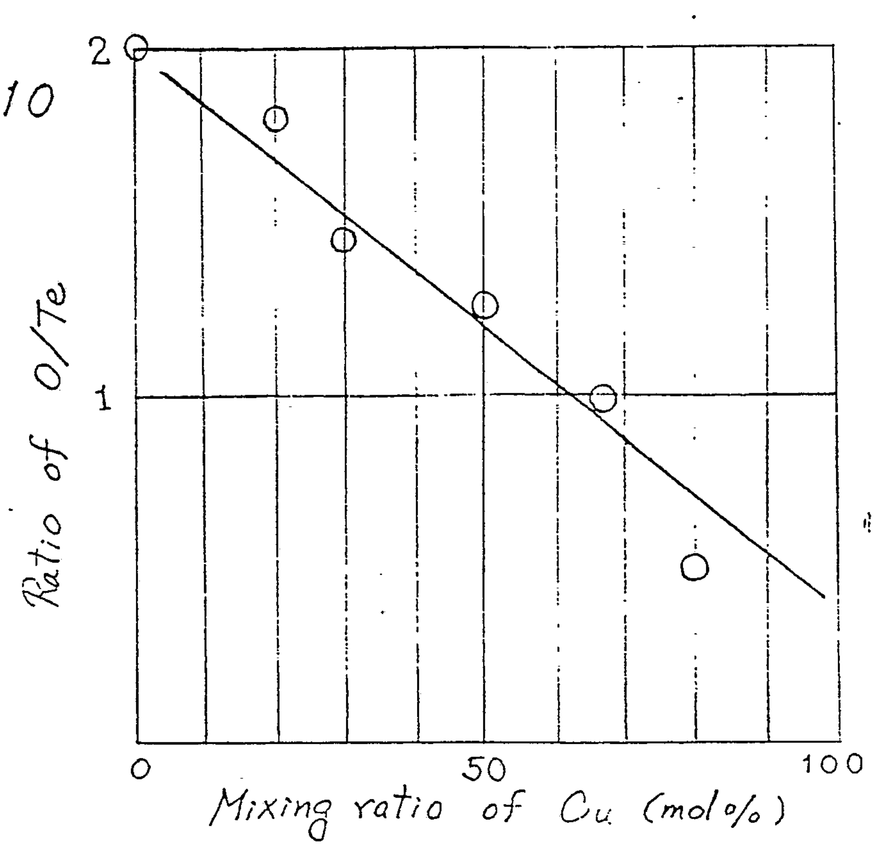
2
1
Ratio of O/Te
0
50
100
Mixing ratio of Cu (mol%)